(19) Europäisches Patentamt
European Patent Office
Office européen des brevets

(11) EP 2 832 760 A1

(12) EUROPEAN PATENT APPLICATION
published in accordance with Art. 153(4) EPC

(43) Date of publication:
**04.02.2015 Bulletin 2015/06**

(21) Application number: **13767851.2**

(22) Date of filing: **21.03.2013**

(51) Int Cl.:
***C08G 59/26*** (2006.01) ***C08G 59/24*** (2006.01)
***C08G 59/42*** (2006.01) ***C08L 67/00*** (2006.01)
***H01L 23/29*** (2006.01) ***H01L 23/31*** (2006.01)

(86) International application number:
**PCT/JP2013/058072**

(87) International publication number:
**WO 2013/146527 (03.10.2013 Gazette 2013/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **28.03.2012 JP 2012074166**

(71) Applicant: **Daicel Corporation**
**Osaka-shi, Osaka 530-0001 (JP)**

(72) Inventor: **SUZUKI, Hirose**
**Ohtake-shi**
**Hiroshima 739-0695 (JP)**

(74) Representative: **Grünecker, Kinkeldey, Stockmair & Schwanhäusser**
**Leopoldstrasse 4**
**80802 München (DE)**

# (54) CURABLE EPOXY RESIN COMPOSITION

(57) Provided is a curable epoxy resin composition capable of forming a cured product that has heat resistance, light resistance, and thermal shock resistance at high levels and particularly offers excellent reflow resistance after moisture absorption. The curable epoxy resin composition includes an alicyclic epoxy compound (A), a monoallyl diglycidyl isocyanurate compound (B) represented by Formula (1), a curing agent (C), and a curing accelerator (D). The composition includes methylnorbornane-2,3-dicarboxylic anhydride as an essential component of the curing agent (C) and has a succinic anhydride content of 0.4 percent by weight or less based on the total amount of the curing agent (C) :

[Chem. 1]

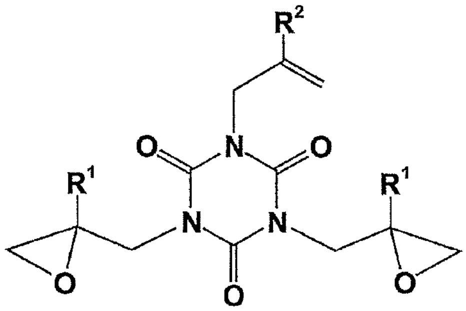

(1)

wherein $R^1$ and $R^2$ are identical or different and each represent a hydrogen atom or an alkyl group having 1 to 8 carbon atoms.

EP 2 832 760 A1

## Description

### Technical Field

The present invention relates to curable epoxy resin compositions; cured products obtained by curing the curable epoxy resin compositions; and optical semiconductor devices including optical semiconductor elements encapsulated with the cured products of the curable epoxy resin compositions.

### Background Art

Optical semiconductor devices have had higher and higher outputs. Resins (encapsulants) for encapsulating optical semiconductor elements in the optical semiconductor devices require heat resistance and light resistance at high levels. A composition has been known as an exemplary encapsulating agent to form a highly heat-resistant encapsulant, where the composition includes monoallyl diglycidyl isocyanurate and a bisphenol-A epoxy resin (see Patent Literature (PTL) 1). Assume that the composition is used as an encapsulating agent for encapsulating an optical semiconductor element of a high-output blue/white optical semiconductor. Disadvantageously in this case, an encapsulant derived from the composition is increasingly colored by light and heat emitted from the optical semiconductor element; the colored encapsulant absorbs light to be outputted normally; and the optical semiconductor device outputs light with a decreasing luminous intensity with time.

Liquid alicyclic epoxy resins having an alicyclic skeleton are known as encapsulating agents to form cured products (encapsulants) that have heat resistance and light resistance at high levels and resist yellowing. The liquid alicyclic epoxy resins are exemplified by 3,4-epoxycyclohexylmethyl (3,4-epoxy)cyclohexanecarboxylate; an adduct of 3,4-epoxycyclohexylmethyl (3,4-epoxy)cyclohexanecarboxylate and ε-caprolactone; and 1,2,8,9-diepoxylimonene. Unfortunately, however, cured products of these alicyclic epoxy resins are sensitive to stress of every kind and suffer typically from cracks (cracking) upon the application of a thermal shock as in a temperature cycle. In the temperature cycle, heating and cooling are periodically repeated.

Optical semiconductor devices (e.g., surface-mounted optical semiconductor devices) generally undergo a reflow process for bonding electrodes of the optical semiconductor devices to circuit boards by soldering. Lead-free solders having high melting points are more and more used as bonding-material solders. This renders a heat treatment in the reflow process to be performed at a higher temperature (e.g., at a peak temperature of 240°C to 260°C). Disadvantageously, the known optical semiconductor devices under these circumstances suffer from deterioration. For example, the heat treatment in the reflow process causes peeling (detachment) of the encapsulants from lead frames of the optical semiconductor devices and/or cracking of the encapsulants.

The encapsulants for use in such optical semiconductor devices require, in addition to the heat resistance and light resistance at high levels, a property of resisting cracking even upon the application of a thermal shock, and a property of resisting cracking and peeling even upon the heat treatment in the reflow process. The former property is hereinafter also referred to as "thermal shock resistance". In particular, the encapsulants require "reflow resistance after moisture absorption" from the viewpoint of ensuring higher reliability of the encapsulants. The "reflow resistance after moisture absorption" refers to such a property that the encapsulant resists the cracking and peeling even after the optical semiconductor device is placed under high-humidity conditions for a predetermined time to absorb moisture and then subjected to a heat treatment in a reflow process. The moisture absorption may be performed typically at 30°C and 70% relative humidity for 168 hours; or at 60°C and 60% relative humidity for 40 hours.

### Citation List

#### Patent Literature

PTL 1: Japanese Unexamined Patent Application Publication (JP-A) No. 2000-344867

### Summary of Invention

#### Technical Problem

Accordingly, an object of the present invention is to provide a curable epoxy resin composition capable of forming a cured product that has heat resistance, light resistance, and thermal shock resistance at high levels and particularly offers excellent reflow resistance after moisture absorption.

Another object of the present invention is to provide a cured product that has heat resistance, light resistance, and thermal shock resistance at high levels and particularly offers excellent reflow resistance after moisture absorption.

Yet another object of the present invention is to provide an optical semiconductor device that less suffers from deterioration such as luminous intensity reduction and, particularly, less suffers from deterioration such as luminous intensity reduction even upon a heat treatment in a reflow process after storage under high-humidity conditions. Solution to Problem

After intensive investigations to achieve the objects, the inventor has found that a specific curable epoxy resin composition is capable of forming a cured product that has heat resistance, light resistance, and thermal shock resistance at high levels and particularly offers excellent reflow resistance after moisture absorption, where the curable epoxy resin composition contains an alicyclic epoxy compound, a monoallyl diglycidyl isocyanurate compound, a curing agent, and a curing accelerator, includes a specific compound as the curing agent, and is adapted to have an amount of succinic anhydride controlled within a specific range based on the total amount of the curing agent. The present invention has been made based on these findings.

Specifically, the present invention provides, in an embodiment, a curable epoxy resin composition that includes: an alicyclic epoxy compound (A); a monoallyl diglycidyl isocyanurate compound (B); a curing agent (C); and a curing accelerator (D), where the monoallyl diglycidyl isocyanurate compound (B) is represented by Formula (1):

[Chem. 1]

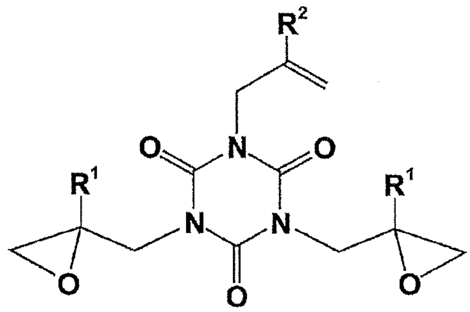

(1)

wherein $R^1$ and $R^2$ are identical or different and are independently selected from a hydrogen atom and an alkyl group having 1 to 8 carbon atoms; the curable epoxy resin composition includes a methylnorbornane-2,3-dicarboxylic anhydride as an essential component of the curing agent (C); and a content of succinic anhydride is 0.4 percent by weight or less based on the total amount of the curing agent (C).

The curable epoxy resin composition may further include norbornane-2,3-dicarboxylic anhydride as the curing agent (C) in addition to the methylnorbornane-2,3-dicarboxylic anhydride.

The alicyclic epoxy compound (A) in the curable epoxy resin composition may be a cyclohexane-oxide-containing compound.

The alicyclic epoxy compound (A) in the curable epoxy resin composition may be a compound represented by Formula (I-1) :

[Chem. 2]

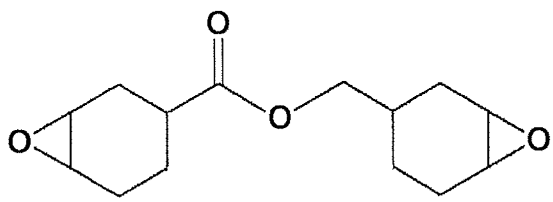

(I-1)

The curable epoxy resin composition may further include a siloxane derivative having at least two epoxy groups per molecule.

The curable epoxy resin composition may further include an alicyclic polyester resin.

The curable epoxy resin composition may further include rubber particles.

The present invention further provides, in another embodiment, a cured product obtained by curing the curable epoxy resin composition.

The curable epoxy resin composition may be used for optical semiconductor encapsulation.

In addition and advantageously, the present invention provides, in yet another embodiment, an optical semiconductor device including an optical semiconductor element encapsulated with the cured product of the curable epoxy

resin composition.

Advantageous Effects of Invention

The curable epoxy resin composition according to the embodiment of the present invention has the configuration and is capable of forming, upon curing, a cured product that has heat resistance, light resistance, and thermal shock resistance at high levels and particularly offers excellent reflow resistance after moisture absorption. The curable epoxy resin composition according to the present invention, upon the use as a resin composition for encapsulation to form an optical semiconductor device, helps the optical semiconductor device to offer high durability and to have high quality. Particularly, the curable epoxy resin composition helps the optical semiconductor device to resist deterioration such as luminous intensity reduction even upon a heat treatment in a reflow process after storage under high-humidity conditions.

Brief Description of Drawings

[Fig. 1] Figs. 1(a) (left hand) and 1(b) (right hand) are a perspective view and a cross-sectional view, respectively, as schematic diagrams illustrating an optical semiconductor device including an optical semiconductor element encapsulated with a cured product of the curable epoxy resin composition according to an embodiment of the present invention.
[Fig. 2] Fig. 2 illustrates an exemplary surface temperature profile (temperature profile in one of two heat treatments) of optical semiconductor devices in soldering heat resistance tests in Examples.

Description of Embodiments

Curable Epoxy Resin Composition

The curable epoxy resin composition according to the present invention is a resin composition including an alicyclic epoxy compound (A); a monoallyl diglycidyl isocyanurate compound (B); a curing agent (C); and a curing accelerator (D), where the monoallyl diglycidyl isocyanurate compound (B) is represented by Formula (1):

[Chem. 3]

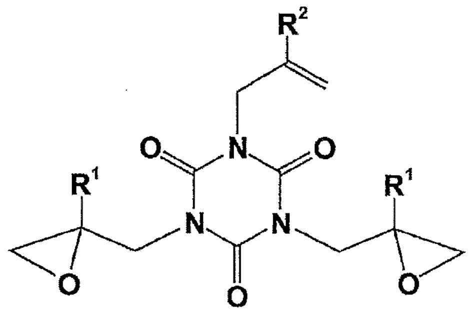

(1)

wherein $R^1$ and $R^2$ are identical or different and are independently selected from a hydrogen atom and an alkyl group having 1 to 8 carbon atoms.

Alicyclic Epoxy Compound (A)

The alicyclic epoxy compound (A) in the curable epoxy resin composition according to the present invention is a compound containing an alicyclic (aliphatic cyclic) structure and at least one epoxy group in the molecule (per molecule). Specifically, the alicyclic epoxy compound (A) is exemplified by (i) compounds having an epoxy group (alicyclic epoxy group) composed of oxygen atom and adjacent two carbon atoms constituting an alicycle; and (ii) compounds including an epoxy group directly bonded to an alicycle via a single bond. Such "alicyclic epoxy compounds (A)" herein exclude after-mentioned siloxane derivatives having at least two epoxy groups per molecule.
The compounds (i) having an epoxy group (alicyclic epoxy group) composed of oxygen atom and adjacent two carbon atoms constituting an alicycle for use herein can be any one selected from known or customary ones. Among them, a cyclohexene oxide group is preferred as the alicyclic epoxy group.

Of the compounds (i) having an epoxy group composed of oxygen atom and adjacent two carbon atoms constituting an alicycle, preferred from the viewpoints of transparency and heat resistance are cyclohexane-oxide-containing compounds, of which particularly preferred are compounds (alicyclic epoxy compounds) represented by Formula (I):

[Chem. 4]

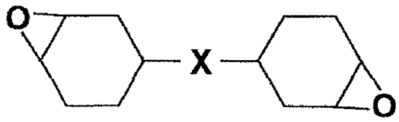

(I)

In Formula (I), X represents a single bond or a linkage group (divalent group having one or more atoms). The linkage group is exemplified by divalent hydrocarbon groups, carbonyl group, ether bond, ester bond, carbonate group, amido group, and groups each including two or more of them linked to each other.

The alicyclic epoxy compound of Formula (I) in which X is a single bond is 3,4,3',4'-diepoxybicyclohexane.

The divalent hydrocarbon groups are exemplified by linear or branched alkylene groups having 1 to 18 carbon atoms; and divalent alicyclic hydrocarbon groups. The linear or branched alkylene groups having 1 to 18 carbon atoms are exemplified by methylene, methylmethylene, dimethylmethylene, ethylene, propylene, and trimethylene groups. The divalent alicyclic hydrocarbon groups are exemplified by divalent cycloalkylene groups (including cycloalkylidene groups), such as 1,2-cyclopentylene, 1,3-cyclopentylene, cyclopentylidene, 1,2-cyclohexylene, 1,3-cyclohexylene, 1,4-cyclohexylene, and cyclohexylidene groups.

Of the linkage groups X, preferred are oxygen-containing linkage groups specifically exemplified by -CO-, -O-CO-O-, -COO-, -O-, -CONH-; groups each including two or more of these groups linked to each other; and groups including one or more of these groups linked to one of more divalent hydrocarbon groups. The divalent hydrocarbon groups are as exemplified above.

The alicyclic epoxy compounds represented by Formula (I) are typified by compounds represented by Formulae (I-1) to (I-10) below. In Formulae (I-5) and (I-7), 1 and m each represent an integer from 1 to 30. In Formula (I-5), R is an alkylene group having 1 to 8 carbon atoms and is exemplified by linear or branched alkylene groups such as methylene, ethylene, propylene, isopropylene, butylene, isobutylene, s-butylene, pentylene, hexylene, heptylene, and octylene groups. Among them, preferred are linear or branched alkylene groups having 1 to 3 carbon atoms, such as methylene, ethylene, propylene, and isopropylene groups. In Formulae (I-9) and (I-10), n1 to n6 each represent an integer from 1 to 30.

[Chem. 5]

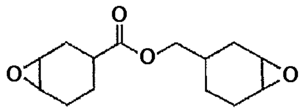

(I−1)

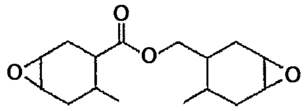

(I−2)

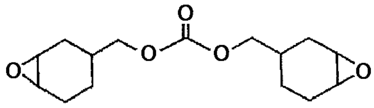

(I−3)

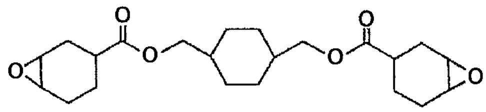

(I−4)

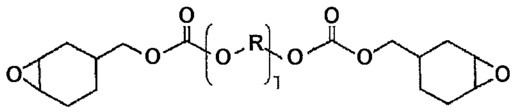

(I−5)

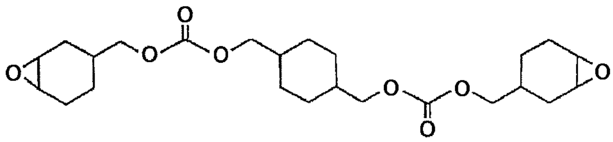

(I−6)

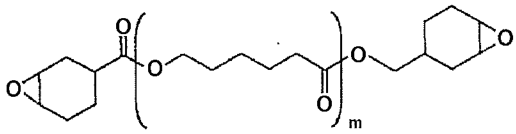

(I−7)

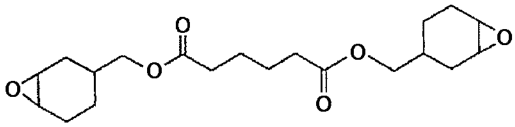

(I−8)

[Chem. 6]

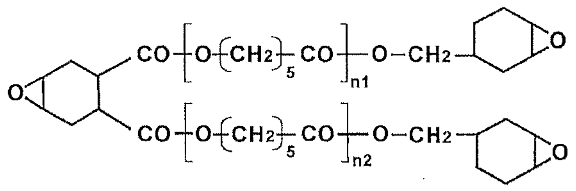

(I-9)

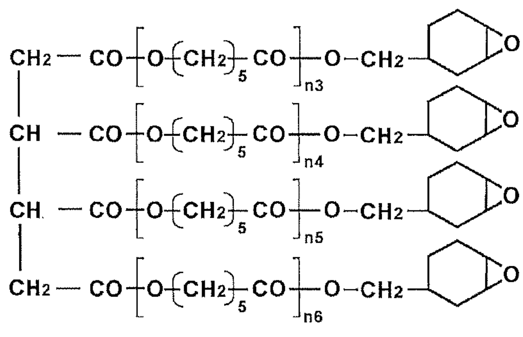

(I-10)

The compounds (ii) including an epoxy group directly bonded to an alicycle via a single bond are exemplified by compounds represented by Formula (II):

[Chem. 7]

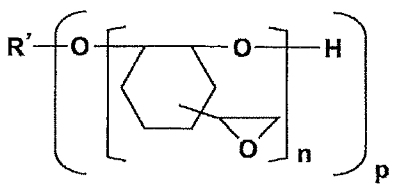

(II)

In Formula (II), R' is a group corresponding to a p-hydric alcohol, except for removing -OH in a number of p from the alcohol; and p and n each represent a natural number. The p-hydric alcohol [R'- (OH) $_p$] is exemplified by polyhydric alcohols (e.g., alcohols having 1 to 15 carbon atoms) such as 2,2-bis(hydroxymethyl)-1-butanol. The number p is preferably from 1 to 6; and n is preferably from 1 to 30. When p is 2 or more, n in p occurrences in the brackets (rounded large brackets) may be identical or different. Specifically, the compounds are exemplified by 1,2-epoxy-4-(2-oxiranyl)cyclohexane adduct of 2,2-bis(hydroxymethyl)-1-butanol or a product under the trade name of EHPE3150 (supplied by Daicel Corporation).

Each of different compound may be used alone or in combination as the alicyclic epoxy compound (A) in the curable epoxy resin composition according to the present invention. The alicyclic epoxy compound (A) is also available as commercial products typically under the trade names of CELLOXIDE 2021P and CELLOXIDE 2081 (each from Daicel Corporation).

The alicyclic epoxy compound (A) is preferably 3,4-epoxycyclohexylmethyl (3,4-epoxy)cyclohexanecarboxylate represented by Formula (I-1) or the product available under the trade name of CELLOXIDE 2021P (from Daicel Corporation).

The curable epoxy resin composition according to the present invention may include the alicyclic epoxy compound (A) in a content (blending amount) not critical, but preferably from 5 to 70 percent by weight, more preferably from 10 to 60 percent by weight, and furthermore preferably from 15 to 50 percent by weight, based on the total amount (100 percent by weight) of the curable epoxy resin composition. The curable epoxy resin composition, if including the alicyclic epoxy compound (A) in a content less than 5 percent by weight, may cause the cured product to be inferior in heat resistance, light resistance, thermal shock resistance, and/or reflow resistance after moisture absorption.

The alicyclic epoxy compound (A) may be present in a content (blending amount) not critical, but preferably from 10 to 95 percent by weight, more preferably from 20 to 92 percent by weight, and furthermore preferably from 30

to 90 percent by weight, based on the total amount (100 percent by weight) of epoxy-containing compounds (total epoxy compounds) in the composition. The alicyclic epoxy compound (A), if present in a content less than 10 percent by weight, may fail to help the cured product to be satisfactory in heat resistance, light resistance, thermal shock resistance, and/or reflow resistance after moisture absorption.

Monoallyl Diglycidyl Isocyanurate Compound (B)

The monoallyl diglycidyl isocyanurate compound (B) in the curable epoxy resin composition according to the present invention is a compound represented by Formula (1) below. The monoallyl diglycidyl isocyanurate compound (B) plays a role particularly in helping the cured product to have better toughness and to thereby have better thermal shock resistance and better reflow resistance after moisture absorption. Particularly, the monoallyl diglycidyl isocyanurate compound (B) plays a role in helping the cured product to have better cracking resistance (a property that resists cracking) in a heat treatment in a reflow process after moisture absorption.

[Chem. 8]

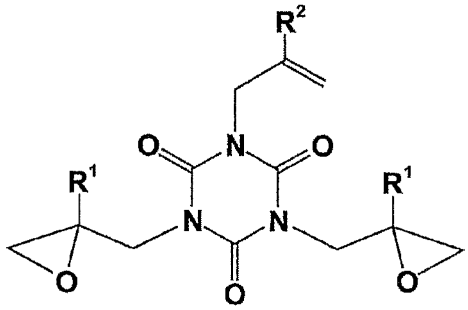

(1)

In Formula (1), $R^1$ and $R^2$ are independently (identical or different) selected from a hydrogen atom and an alkyl group having 1 to 8 carbon atoms. The alkyl group having 1 to 8 carbon atoms is exemplified by linear or branched alkyl groups such as methyl, ethyl, propyl, isopropyl, butyl, isobutyl, s-butyl, pentyl, hexyl, heptyl, and octyl groups. Among them, preferred are linear or branched alkyl groups having 1 to 3 carbon atoms, such as methyl, ethyl, propyl, and isopropyl groups. $R^1$ and $R^2$ in Formula (1) are particularly preferably hydrogen atoms.

The monoallyl diglycidyl isocyanurate compound (B) is typified by monoallyl diglycidyl isocyanurate, 1-allyl-3,5-bis(2-methylepoxypropyl) isocyanurate, 1-(2-methylpropenyl)-3,5-diglycidyl isocyanurate, and 1-(2-methylpropenyl)-3,5-bis(2-methylepoxypropyl) isocyanurate. Each of different compounds may be used alone or in combination as the monoallyl diglycidyl isocyanurate compound (B).

The monoallyl diglycidyl isocyanurate compound (B) may be used after being modified with a compound that reacts with epoxy group, such as an alcohol or an acid anhydride.

The monoallyl diglycidyl isocyanurate compound (B) may be present in a content (blending amount) not critical, but preferably from 5 to 60 percent by weight, more preferably from 8 to 55 percent by weight, and furthermore preferably from 10 to 50 percent by weight, based on the total amount (100 percent by weight) of epoxy-containing compounds in the curable epoxy resin composition. The monoallyl diglycidyl isocyanurate compound (B), if present in a content greater than 60 percent by weight, may suffer from inferior solubility in the curable epoxy resin composition, and this may adversely affect properties of the cured product. In contrast, the monoallyl diglycidyl isocyanurate compound (B), if present in a content less than 5 percent by weight, may fail to help the cured product to be satisfactory in thermal shock resistance and/or reflow resistance after moisture absorption.

The monoallyl diglycidyl isocyanurate compound (B) may be present in a content (blending amount) not critical, but preferably from 5 to 60 percent by weight, more preferably from 8 to 55 percent by weight, and furthermore preferably from 10 to 50 percent by weight, based on the total amount (100’ percent by weight) of the alicyclic epoxy compound (A) and the monoallyl diglycidyl isocyanurate compound (B). The monoallyl diglycidyl isocyanurate compound (B), if present in a content greater than 60 percent by weight, may suffer from inferior solubility in the curable epoxy resin composition, and this may adversely affect the properties of the cured product. In contrast, the monoallyl diglycidyl isocyanurate compound (B), if present in a content less than 5 percent by weight, may fail to help the cured product to be satisfactory in thermal shock resistance and/or reflow resistance after moisture absorption.

Curing Agent (C)

The curing agent (C) in the curable epoxy resin composition according to the present invention is a compound

that functionally cures epoxy-containing compounds. Each of different compounds may be used alone or in combination as the curing agent (C) in the curable epoxy resin composition according to the present invention.

The curable epoxy resin composition according to the present invention includes a methylnorbornane-2,3-dicarboxylic anhydride as an essential component of the curing agent (C). This particularly helps the cured product to have better reflow resistance after moisture absorption. As used herein the term "methylnorbornane-2,3-dicarboxylic anhydride" is a generic name of isomers having methyl group at different positions on the norbornane ring. The methylnorbornane-2,3-dicarboxylic anhydride is typified by 5-methylnorbornane-2,3-dicarboxylic anhydride.

The methylnorbornane-2,3-dicarboxylic anhydride is present as exo- and endo-stereoisomers. The methylnorbornane-2,3-dicarboxylic anhydride becomes liquid at room temperature more readily and can be treated as the curing agent (C) more easily with an increasing abundance ratio of the exo isomer thereof. The methylnorbornane-2,3-dicarboxylic anhydride therefore preferably includes the exo isomer as an essential component. More specifically, the methylnorbornane-2,3-dicarboxylic anhydride has an abundance ratio of the exo isomer of preferably 40 percent by weight or more, and more preferably 50 percent by weight or more, where the abundance ratio is calculated by dividing the amount of exo isomer by the total amount of the exo and endo isomers, as [(exo isomer)/[(exo isomer)+(endo isomer)]]. The methylnorbornane-2,3-dicarboxylic anhydride, if having an exo isomer abundance ratio of less than 40 percent by weight, may readily become solid at room temperature and become difficult to handle.

The methylnorbornane-2,3-dicarboxylic anhydride may be prepared by hydrogenating a corresponding methylnorbornene-2,3-dicarboxylic anhydride. Isomerization of at least part of the endo isomer into the exo isomer is preferably performed in a production process of the methylnorbornane-2,3-dicarboxylic anhydride. This is preferred particularly from the viewpoint of increasing the exo isomer abundance ratio to allow the methylnorbornane-2,3-dicarboxylic anhydride to be liquid at room temperature. More specifically, the methylnorbornane-2,3-dicarboxylic anhydride is preferably produced by isomerizing part or all of a methylnorbornene-2,3-dicarboxylic anhydride into a corresponding methylenenorbornane-2,3-dicarboxylic anhydride in the presence of an acid catalyst; and subsequently hydrogenating the resulting compound (see, for example, JP-A No. H06-25207).

The curing agent (C) may contain the methylnorbornane-2,3-dicarboxylic anhydride in a content (percentage) not critical, but preferably from 70 to 100 percent by weight, more preferably from 75 to 100 percent by weight, and furthermore preferably from 80 to 100 percent by weight, based on the total amount (100 percent by weight) of the curing agent (C) in the curable epoxy resin composition. The curing agent (C), if containing the methylnorbornane-2,3-dicarboxylic anhydride in a content less than 70 percent by weight, may cause the cured product to have inferior reflow resistance after moisture absorption.

The curable epoxy resin composition according to the present invention may further include norbornane-2,3-dicarboxylic anhydride as the curing agent (C). Specifically, the curable epoxy resin composition according to the present invention may include both the methylnorbornane-2,3-dicarboxylic anhydride and norbornane-2,3-dicarboxylic anhydride as the curing agent (C).

The norbornane-2,3-dicarboxylic anhydride includes exo and endo stereoisomers, as with the methylnorbornane-2,3-dicarboxylic anhydride. The norbornane-2,3-dicarboxylic anhydride becomes liquid at room temperature more readily and can be handled as the curing agent (C) more easily with an increasing abundance ratio of the exo isomer thereof. For this reason, the norbornane-2,3-dicarboxylic anhydride preferably includes the exo isomer as an essential component. More specifically, the exo isomer abundance ratio in the norbornane-2,3-dicarboxylic anhydride is preferably 30 percent by weight or more, and more preferably 40 percent by weight or more, where the abundance ratio is calculated by dividing the amount of the exo isomer by the total amount of the exo and endo isomers, as [(exo isomer)/[(exo isomer)+(endo isomer)]]. The norbornane-2,3-dicarboxylic anhydride, if having an exo isomer abundance ratio less than 30 percent by weight, may readily become solid at room temperature and become difficult to handle.

The norbornane-2,3-dicarboxylic anhydride may be prepared by preparing norbornene-2,3-dicarboxylic anhydride by a Diels-Alder reaction between cyclopentadiene and maleic anhydride; and hydrogenating the norbornene-2,3-dicarboxylic anhydride. However, the norbornene-2,3-dicarboxylic anhydride prepared by the Diels-Alder reaction between cyclopentadiene and maleic anhydride generally includes the endo isomer in an abundance ratio of 95 percent by weight or more. This compound is preferably subjected to heating to 150°C or higher to be isomerized (thermally isomerized) into the exo isomer; and subsequently subjected to a hydrogenation reaction. This is preferred for the formation of norbornane-2,3-dicarboxylic anhydride including the exo isomer in a high abundance ratio (e.g., norbornane-2,3-dicarboxylic anhydride including the exo isomer in an abundance ratio of 30 percent by weight or more).

The methylnorbornane-2,3-dicarboxylic anhydride and norbornane-2,3-dicarboxylic anhydride may be used as a mixture upon the use as the curing agent (C). The mixture may be prepared by mixing the methylnorbornane-2,3-dicarboxylic anhydride with norbornane-2,3-dicarboxylic anhydride; or may be produced by mixing a methylnorbornene-2,3-dicarboxylic anhydride with norbornene-2,3-dicarboxylic anhydride to give a mixture and isomerizing and hydrogenating the mixture.

The curing agent (C) may include the norbornane-2,3-dicarboxylic anhydride in a content (percentage) not critical, but preferably from 0 to 30 percent by weight, more preferably from 0 to 25 percent by weight, and furthermore

preferably from 0 to 20 percent by weight, based on the total amount (100 percent by weight) of the curing agent (C) included in the curable epoxy resin composition. The curing agent (C), if including the norbornane-2,3-dicarboxylic anhydride in a content greater than 30 percent by weight, may cause the cured product to have inferior reflow resistance after moisture absorption. The curing agent (C), when further including the norbornane-2,3-dicarboxylic anhydride, may include the methylnorbornane-2,3-dicarboxylic anhydride and norbornane-2,3-dicarboxylic anhydride in a total sum of their contents (total content) not critical, but preferably from 80 to 100 percent by weight, and more preferably from 90 to 100 percent by weight, based on the total amount (100 percent by weight) of the curing agent (C). The curing agent (C), if containing the two compounds in a total content less than 80 percent by weight, may cause the cured product to have inferior reflow resistance after moisture absorption.

The curable epoxy resin composition according to the present invention may further include, as the curing agent (C), another curing agent than the methylnorbornane-2,3-dicarboxylic anhydride and norbornane-2,3-dicarboxylic anhydride. The other curing agent is also referred to as "additional curing agent". The additional curing agent is exemplified by acid anhydrides that are liquid at 25°C, such as methyltetrahydrophthalic anhydride, methylhexahydrophthalic anhydride, dodecenylsuccinic anhydride, and methyl-endomethylenetetrahydrophthalic anhydride; and acid anhydrides that are solid at room temperature (about 25°C), such as phthalic anhydride, tetrahydrophthalic anhydride, hexahydrophthalic anhydride, and methylcyclohexenedicarboxylic anhydride. Among them, preferred as the additional curing agent are anhydrides of saturated monocyclic hydrocarbon dicarboxylic acids (including those having a substituent (e.g., alkyl) bonded to the ring). These are preferred from the viewpoints of heat resistance, light resistance, and cracking resistance of the cured product. The curing agent (C) (100 percent by weight) may include the additional curing agent in a content of preferably 20 percent by weight or less (e.g., from 0 to 20 percent by weight), and more preferably 10 percent by weight or less.

The additional curing agent usable herein is also available as commercial products typically under the trade names of RIKACID MH-700 and RIKACID MH-700F (each from New Japan Chemical Co., Ltd.); and the trade name of HN-5500 (from Hitachi Chemical Company, Ltd.). There may also be employed commercial products as a mixture of the additional curing agent and an after-mentioned alicyclic polyester resin, typically under the trade names of HN-7200 and HN-5700 (each from Hitachi Chemical Company, Ltd.).

The curable epoxy resin composition according to the present invention has a content (percentage) of succinic anhydride of 0.4 percent by weight or less, and preferably 0.2 percent by weight or less, based on the total amount of the curing agent (C). Assume that the curable epoxy resin composition has a succinic anhydride content greater than 0.4 percent by weight. Disadvantageously in this case, the curable epoxy resin composition may offer inferior workability due to succinic anhydride precipitation in the curing agent (C) and/or in the composition and, with some types of curing accelerators, cause the cured product to be colored.

Succinic anhydride in the curing agent (C) may be formed as a by-product in the formation of the methylnorbornane-2,3-dicarboxylic anhydride, norbornane-2,3-dicarboxylic anhydride, or a mixture of them by isomerizing and hydrogenating methylnorbornene-2,3-dicarboxylic anhydride, norbornene-2,3-dicarboxylic anhydride, or a mixture of them. More specifically, the isomerization is performed at an elevated temperature around 180°C in the presence of an acid catalyst; this causes dissociation of methylnorbornene-2,3-dicarboxylic anhydride into maleic anhydride and methylcyclopentadiene and dissociation of norbornene-2,3-dicarboxylic anhydride into maleic anhydride and cyclopentadiene to proceed; and the formed maleic anhydride is hydrogenated to form succinic anhydride. A way to control the succinic anhydride content to 0.4 percent by weight or less based on the total amount of the curing agent (C) is exemplified by distillation of methylnorbornane-2,3-dicarboxylic anhydride, norbornane-2,3-dicarboxylic anhydride, or a mixture of them under reduced pressure. More specifically, the distillation may be performed typically by distilling the material at 138°C and 0.27 kPa, removing 5% to 10% of a first fraction, and further distilling the remainder at 173°C and 0.27 kPa.

The curing agent (C) may be present in a content (blending amount) not critical, but preferably from 50 to 200 parts by weight, and more preferably from 100 to 145 parts by weight, per 100 parts by weight of the total amount of epoxy-containing compounds in the curable epoxy resin composition according to the present invention. More specifically, the curing agent (C) is present in such a proportion of preferably 0.5 to 1.5 equivalents per 1 equivalent of epoxy groups in all epoxy-containing compounds included in the curable epoxy resin composition according to the present invention. The curing agent (C), if present in a content less than 50 parts by weight, may cause insufficient curing and cause the cured product to have inferior toughness. The curing agent (C), if present in a content greater than 200 parts by weight, may cause the cured product to be colored and to have inferior hue. As used herein the term "content" of the curing agent (C) refers to the total amount of compounds included as the curing agent (C) in the curable epoxy resin composition.

Curing Accelerator (D)

The curing accelerator (D) in the curable epoxy resin composition according to the present invention is a compound that functionally increases the curing rate upon curing of epoxy-containing compounds by the curing agent. The curing accelerator (D) usable herein is exemplified by known or customary curing accelerators such as 1,8-diazabicyclo[5.4.0]undecene-7 (DBU), and salts thereof such as phenol salt, octanoic acid salt, p-toluenesulfonic acid salt, formic acid salt, and tetraphenylborate salt; 1,5-diazabicyclo[4.3.0]nonene-5 (DBN), and salts thereof such as phenol salt, octanoic acid salt, p-toluenesulfonic acid salt, formic acid salt, and tetraphenylborate salt; tertiary amines such as benzyldimethylamine, 2,4,6-tris(dimethylaminomethyl)phenol, and N,N-dimethylcyclohexylamine; imidazoles such as 2-ethyl-4-methylimidazole and 1-cyanoethyl-2-ethyl-4-methylimidazole; phosphoric esters, triphenylphosphine and other phosphines; phosphonium compounds such as tetraphenylphosphonium tetra(p-tolyl)borate; organometallic salts such as zinc octanoate and tin octanoate; and metal chelates. Each of different compounds may be used alone or in combination as the curing accelerator (D).

The curing accelerator (D) for use herein is also available as commercial products typically under the trade names of U-CAT SA 506, U-CAT SA 102, U-CAT 5003, U-CAT 18X, and 12XD (product under development) (each from San-Apro Ltd.); TPP-K and TPP-MK (each from Hokko Chemical Industry Co., Ltd.); and PX-4ET (from Nippon Chemical Industrial Co., Ltd.).

The curing accelerator (D) may be present in a content (blending amount) not critical, but preferably from 0.05 to 5 parts by weight, more preferably from 0.1 to 3 parts by weight, furthermore preferably from 0.2 to 3 parts by weight, and particularly preferably from 0.25 to 2.5 parts by weight, per 100 parts by weight of the total amount of epoxy-containing compounds in the curable epoxy resin composition. The curing accelerator (D), if present in a content less than 0.05 part by weight, may fail to sufficiently accelerate the curing. In contrast, the curing accelerator (D), if present in a content greater than 5 parts by weight, may cause the cured product to be colored and to have inferior hue.

## Alicyclic Polyester Resin

The curable epoxy resin composition according to the present invention preferably further includes an alicyclic polyester resin. The presence of the alicyclic polyester resin may particularly help the cured product to have heat resistance and light resistance at higher levels and may often further protect the optical semiconductor device from luminous intensity reduction. The "alicyclic polyester resin" refers to a polyester resin having at least an alicyclic structure (aliphatic cyclic structure). The alicyclic polyester resin is preferably one having an alicycle (alicyclic structure) in its principal chain. This is preferred particularly from the viewpoints of heat resistance and light resistance of the cured product at higher levels.

The alicyclic structure in the alicyclic polyester resin is exemplified by, but not limited to, monocyclic hydrocarbon structures; and bridged hydrocarbon structures such as structures of bicyclic hydrocarbons. Among them, particularly preferred are saturated monocyclic hydrocarbon structures and saturated bridged hydrocarbon structures in which the entire alicyclic skeleton is composed of carbon-carbon single bonds. The alicyclic structure in the alicyclic polyester resin may be introduced into any moiety not critical and may be introduced into either one or both of a constitutional unit derived from a dicarboxylic acid; and a constitutional unit derived from a diol.

The alicyclic polyester resin has a constitutional unit derived from a monomer component having an alicyclic structure. The monomer having an alicyclic structure is not limited and may be selected from known or customary diols and dicarboxylic acids each having an alicyclic structure. These compounds are exemplified by dicarboxylic acids (including acid anhydrides and other derivatives) having an alicyclic structure, such as 1,2-cyclohexanedicarboxylic acid, 1,3-cyclohexanedicarboxylic acid, 1,4-cyclohexanedicarboxylic acid, 4-methyl-1,2-cyclohexanedicarboxylic acid, himic acid, 1,4-decahydronaphthalenedicarboxylic acid, 1,5-decahydronaphthalenedicarboxylic acid, 2,6-decahydronaphthalenedicarboxylic acid, and 2,7-decahydronaphthalenedicarboxylic acid; and diols (including derivatives of them) having an alicyclic structure, including five-membered diols such as 1,2-cyclopentanediol, 1,3-cyclopentanediol, 1,2-cyclopentanedimethanol, 1,3-cyclopentanedimethanol, and bis(hydroxymethyl)tricyclo[5.2.1.0]decane, six-membered diols such as 1,2-cyclohexanediol, 1,3-cyclohexanediol, 1,4-cyclohexanediol, 1,2-cyclohexanedimethanol, 1,3-cyclohexanedimethanol, 1,4-cyclohexanedimethanol, and 2,2-bis-(4-hydroxycyclohexyl)propane, and hydrogenated bisphenol-A.

The alicyclic polyester resin may further have a constitutional unit derived from a monomer component devoid of alicyclic structures. The monomer devoid of alicyclic structures is exemplified by structures of aromatic dicarboxylic acids (including acid anhydrides and other derivatives) such as terephthalic acid, isophthalic acid, phthalic acid, and naphthalenedicarboxylic acid; aliphatic dicarboxylic acids (including acid anhydrides and other derivatives) such as adipic acid, sebacic acid, azelaic acid, succinic acid, fumaric acid, and maleic acid; and diols (including derivatives of them) such as ethylene glycol, propylene glycol, 1,2-propanediol, 1,3-propanediol, 1,3-butanediol, 1,4-butanediol, neopentyl glycol, 1,5-pentanediol, 1,6-hexanediol, 3-methylpentanediol, diethylene glycol, 3-methyl-1,5-pentanediol, 2-methyl-1,3-propanediol, 2,2-diethyl-1,3-propanediol, 2-butyl-2-ethyl-1,3-propanediol, xylylene glycol, an ethylene oxide adduct of bisphenol-A, and a propylene oxide adduct of bisphenol-A. Such monomers devoid of alicyclic structures for use herein further include compounds corresponding to the dicarboxylic acids and diols each devoid of alicyclic structures, except with a suitable substituent (e.g., an alkyl group, an alkoxy group, or a halogen atom) bonded thereto.

The monomeric unit having an alicycle may be present in a percentage not critical, but preferably 10 mole percent or more (e.g., from 10 to 80 mole percent), more preferably from 25 to 70 mole percent, and furthermore preferably

from 40 to 60 mole percent, based on the total amount (100 mole percent) of all monomeric units (all monomer components) to constitute the alicyclic polyester resin. The monomeric unit having an alicycle, if present in a percentage less than 10 mole percent, may fail to help the cured product to be satisfactory in heat resistance, light resistance, thermal shock resistance, and/or reflow resistance after moisture absorption.

The alicyclic polyester resin is particularly preferably any of alicyclic polyester resins including at least one of constitutional units represented by Formulae (2) to (4):

[Chem. 9]

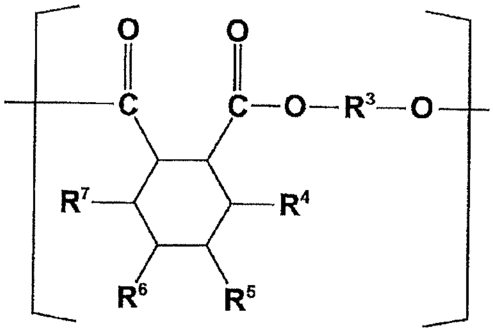

(2)

wherein $R^3$ represents a linear, branched, or cyclic alkylene group having 2 to 15 carbon atoms; and $R^4$ to $R^7$ each represent a hydrogen atom, or a linear or branched alkyl group having 1 to 4 carbon atoms, where two selected from $R^4$ to $R^7$ may be combined to form a ring;

[Chem. 10]

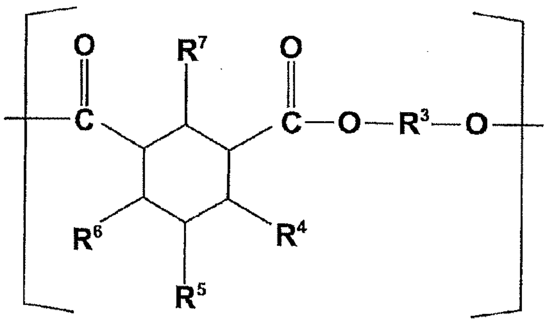

(3)

wherein $R^3$ represents a linear, branched, or cyclic alkylene group having 2 to 15 carbon atoms; and $R^4$ to $R^7$ each represent a hydrogen atom, or a linear or branched alkyl group having 1 to 4 carbon atoms, where two selected from $R^4$ to $R^7$ may be combined to form a ring;

[Chem. 11]

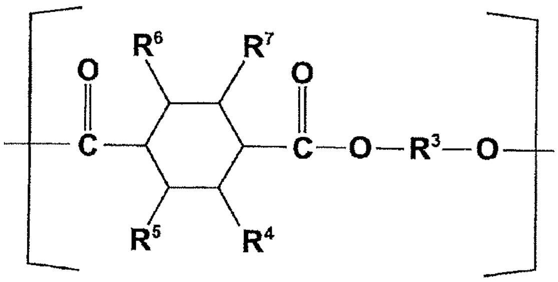

(4)

wherein $R^3$ represents a linear, branched, or cyclic alkylene group having 2 to 15 carbon atoms; and $R^4$ to $R^7$ each represent a hydrogen atom, or a linear or branched alkyl group having 1 to 4 carbon atoms, where two selected from $R^4$ to $R^7$ may be combined to form a ring.

A preferred example of the constitutional units represented by Formulae (2) to (4) is a constitutional unit derived from 4-methyl-1,2-cyclohexanedicarboxylic acid and ethylene glycol and represented by Formula (5) below. An alicyclic polyester resin having the constitutional unit may be available typically by polycondensing methylhexahydrophthalic anhydride and ethylene glycol.

[Chem. 12]

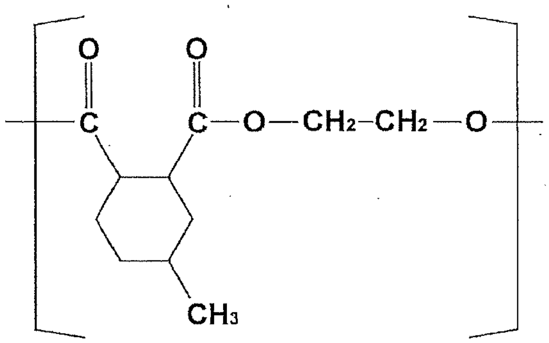

(5)

Another preferred example of the constitutional units represented by Formulae (2) to (4) is a constitutional unit derived from 1,4-cyclohexanedicarboxylic acid and neopentyl glycol and represented by Formula (6) below. An alicyclic polyester resin having the constitutional unit may be available typically by polycondensing 1,4-cyclohexanedicarboxylic acid and neopentyl glycol.

[Chem. 13]

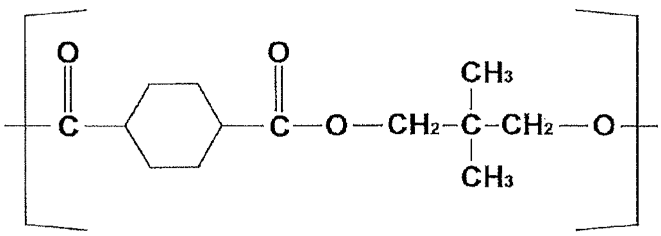

(6)

In an embodiment, the alicyclic polyester resin has one or more of the constitutional units represented by Formulae (2) to (4). The alicyclic polyester resin in this embodiment may include the constitutional unit(s) in a total sum of their contents (total content; the amount of all monomeric units constituting the constitutional unit(s)) not critical, but preferably 20 mole percent or more (e.g., from 20 to 100 mole percent), more preferably from 50 to 100 mole percent, and furthermore preferably from 80 to 100 mole percent, based on the total amount (100 mole percent) of all constitutional units constituting the alicyclic polyester resin (all monomeric units constituting the alicyclic polyester resin). The alicyclic polyester resin, if including the constitutional unit(s) represented by Formulae (2) to (4) in a content less than 20 mole percent, may fail to help the cured product to be satisfactory in heat resistance, light resistance, thermal shock resistance, and/or reflow resistance after moisture absorption.

The alicyclic polyester resin may have a number-average molecular weight not critical, but preferably from 300 to 100000, and more preferably from 300 to 30000. The alicyclic polyester resin, if having a number-average molecular weight less than 300, may cause the cured product to have insufficient toughness and to be inferior in thermal shock resistance and/or reflow resistance after moisture absorption. In contrast, the alicyclic polyester resin, if having a number-average molecular weight greater than 100000, may have inferior compatibility with the curing agent (C) to cause the cured product to have inferior transparency. The number-average molecular weight of the alicyclic polyester resin may be measured typically as a value in terms of a polystyrene standard by gel permeation chromatography (GPC).

Each of different alicyclic polyester resins may be used alone or in combination.

The alicyclic polyester resin can be produced by any known or customary method not limited. More specifically,

the alicyclic polyester resin may be obtained typically by polycondensing the dicarboxylic acid and the diol according to a common procedure; or by polycondensing a derivative (e.g., an acid anhydride, ester, or acid halide) of the dicarboxylic acid with the diol according to a common procedure.

The alicyclic polyester resin in the curable epoxy resin composition according to the present invention may be present in a content (blending amount) not critical, but preferably from 1 to 60 percent by weight, and more preferably from 5 to 30 percent by weight, based on the total amount (100 percent by weight) of the alicyclic polyester resin and the curing agent (C). The alicyclic polyester resin, if present in a content less than 1 percent by weight, may fail to help the cured product to be sufficient in thermal shock resistance and/or reflow resistance after moisture absorption. In contrast, the alicyclic polyester resin, if present in a content greater than 60 percent by weight, may cause the cured product to have inferior transparency and/or inferior heat resistance.

The alicyclic polyester resin may be present in a content (blending amount) not critical, but preferably from 5 to 60 parts by weight, more preferably from 10 to 50 parts by weight, and furthermore preferably from 15 to 50 parts by weight, per 100 parts by weight of the alicyclic epoxy compound (A). The alicyclic polyester resin, if present in a content less than 5 parts by weight, may fail to help the cured product to be satisfactory in heat resistance, light resistance, thermal shock resistance, and/or reflow resistance after moisture absorption. In contrast, the alicyclic polyester resin, if present in a content greater than 60 parts by weight, may cause the cured product to have inferior thermal shock resistance and/or inferior reflow resistance after moisture absorption.

Siloxane Derivative Containing Two or More Epoxy Groups per Molecule

The curable epoxy resin composition according to the present invention preferably further includes a siloxane derivative having two or more epoxy groups in the molecule (per molecule). The presence of the siloxane derivative having at least two epoxy groups per molecule particularly helps the cured product to have heat resistance and light resistance at still higher levels.

The siloxane skeleton (Si-O-Si skeleton) in the siloxane derivative having at least two epoxy groups per molecule is exemplified by, but not limited to, cyclic siloxane skeletons; and polysiloxane skeletons such as skeletons of linear silicones, and of cage-like or ladder-like polysilsesquioxanes. Among them, cyclic siloxane skeletons and linear silicone skeletons are preferred as the siloxane skeleton, from the viewpoints of helping the cured product to have better heat resistance and better light resistance to thereby less cause luminous intensity reduction. Specifically, preferred as the siloxane derivative having at least two epoxy groups per molecule are cyclic siloxanes having at least two epoxy groups per molecule; and linear silicones having at least two epoxy groups per molecule. Each of different siloxane derivatives having at least two epoxy groups per molecule may be used alone or in combination.

A cyclic siloxane having two or more epoxy groups, when employed as the siloxane derivative having at least two epoxy groups per molecule, may include Si-O units defining its siloxane ring in a number not critical, but preferably from 2 to 12, and more preferably from 4 to 8. The number of Si-O units equals to the number of silicon atoms defining the siloxane ring. The number range is preferred from the viewpoint of helping the cured product to have better heat resistance and better light resistance.

The siloxane derivative having at least two epoxy groups per molecule may have a weight-average molecular weight not critical, but preferably from 100 to 3000, and more preferably from 180 to 2000. The range is preferred from the viewpoint of helping the cured product to have better heat resistance and better light resistance.

The siloxane derivative having at least two epoxy groups per molecule may have epoxy groups in the number per molecule of not critical, as long as being two or more, but preferably in the number of two to four (two, three, or four). The range is preferred from the viewpoint of helping the cured product to have better heat resistance and better light resistance.

The siloxane derivative having at least two epoxy groups per molecule may have an epoxy equivalent not critical, but preferably from 180 to 400, more preferably from 240 to 400, and furthermore preferably from 240 to 350, from the viewpoint of helping the cured product to have better heat resistance and better light resistance. The epoxy equivalent may be determined according to JIS K7236.

The epoxy groups in the siloxane derivative having at least two epoxy groups per molecule are not limited, but preferably epoxy groups (alicyclic epoxy groups) each composed of oxygen atom and adjacent two carbon atoms constituting an aliphatic ring, of which cyclohexene oxide groups are particularly preferred. These epoxy groups are preferred from the viewpoint of helping the cured product to have better heat resistance and better light resistance.

The siloxane derivative having at least two epoxy groups per molecule is specifically exemplified by 2,4-di[2-(3-{oxabicyclo[4.1.0]heptyl})ethyl]-2,4,6,6,8,8-hexamethyl-cyclotetrasiloxane, 4,8-di[2-(3-{oxabicyclo[4.1.0]heptyl})ethyl]-2,2,4,6,6,8-hexamethyl-cyclotetrasiloxane, 2,4-di[2-(3-{oxabicyclo[4.1.0]heptyl})ethyl]-6,8-dipropyl-2,4,6,8-tetramethyl-cyclotetrasiloxane, 4,8-di[2-(3-{oxabicyclo[4.1.0]heptyl})ethyl]-2,6-dipropyl-2,4,6,8-tetramethyl-cyclotetrasiloxane, 2,4,8-tri[2-(3-{oxabicyclo[4.1.0]heptyl})ethyl]-2,4,6,6,8-pentamethylcyclotetrasiloxane, 2,4,8-tri[2-(3-{oxabicyclo[4.1.0]heptyl})ethyl]-6-propyl-2,4,6,8-tetramethyl-cyclotetrasiloxane, 2,4,6,8-tetra[2-(3-{oxabicyclo[4.1.0]heptyl})ethyl]-2,4,6,8-tetramethyl-cyclotetrasiloxane, and silsesquioxanes having at least two epoxy groups per molecule. More specific examples include cyclic siloxanes having at least two epoxy groups per molecule and represented by the formulae:

[Chem. 14]

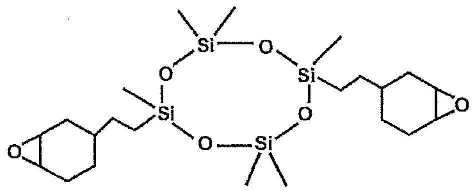

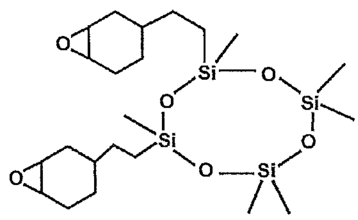

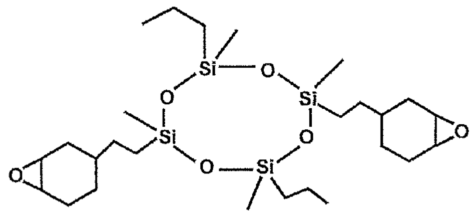

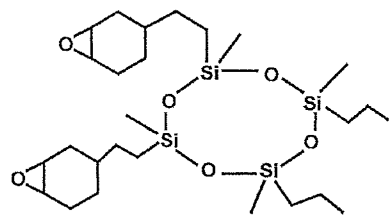

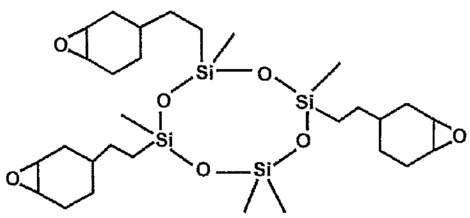

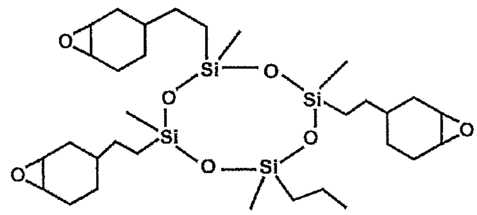

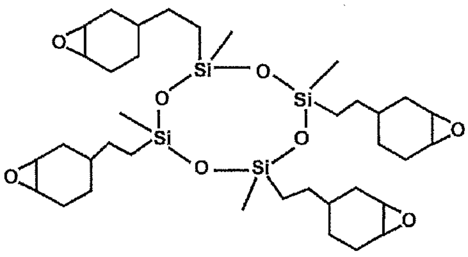

The siloxane derivative having at least two epoxy groups per molecule usable herein is further exemplified by alicyclic-epoxy-containing silicone resins described in JP-A No. 2008-248169; and organopolysilsesquioxane resins having at least two epoxy functional groups per molecule as described in JP-A No. 2008-19422.

The siloxane derivative having at least two epoxy groups per molecule usable herein is also available as commercial products typically under the trade names of X-40-2678, X-40-2670, and X-40-2720 (each from Shin-Etsu Chemical Co., Ltd.) as cyclic siloxanes having at least two epoxy groups per molecule.

The siloxane derivative having at least two epoxy groups per molecule may be present in a content (blending amount) not critical, but preferably from 5 to 60 percent by weight, more preferably from 8 to 55 percent by weight, furthermore preferably from 10 to 50 percent by weight, and particularly preferably from 15 to 40 percent by weight, based on the total amount (100 percent by weight) of epoxy-containing compounds in the curable epoxy resin composition. The siloxane derivative having at least two epoxy groups per molecule, if present in a content less than 5 percent by weight, may fail to help the cured product to be sufficient in heat resistance and/or light resistance. In contrast, the siloxane derivative having at least two epoxy groups per molecule, if present in a content greater than 60 percent by weight, may cause the cured product to have inferior thermal shock resistance and/or inferior reflow resistance after

moisture absorption.

The siloxane derivative having at least two epoxy groups per molecule may be prevent in a content (blending amount) per 100 parts by weight of the alicyclic epoxy compound (A) not critical, but preferably from 10 to 200 parts by weight, more preferably from 20 to 180 parts by weight, furthermore preferably from 30 to 150 parts by weight, and particularly preferably from 35 to 145 parts by weight. The siloxane derivative having at least two epoxy groups per molecule, if present in a content less than 10 parts by weight, may fail to help the cured product to be satisfactory in heat resistance and/or light resistance. In contrast, the siloxane derivative having at least two epoxy groups per molecule, if present in a content greater than 200 parts by weight, may cause the cured product to have inferior thermal shock resistance and/or inferior reflow resistance after moisture absorption.

Rubber Particles

The curable epoxy resin composition according to the present invention may further include rubber particles. The rubber particles are exemplified by particles of rubbers such as particulate NBR (acrylonitrile-butadiene rubber), carboxy-terminated butadiene-acrylonitrile rubber (CTBN), metal-free NBR, and particulate SBR (styrene-butadiene rubber). The rubber particles are preferably those having a multilayer structure (core-shell structure) including an elastomeric core and at least one shell layer covering the core. The rubber particles are particularly preferably specific rubber particles as follows. The specific rubber particles include a polymer composed of a (meth)acrylic ester as an essential monomer component and have, in the surface, a hydroxyl group and/or a carboxy group (either one or both of hydroxyl group and carboxy group) as a functional group that is reactive with an epoxy-containing compound such as the alicyclic epoxy compound (A). The rubber particles, if devoid of hydroxyl groups and carboxy groups in the surface, may undesirably cause the cured product to become cloudy by a thermal shock such as a temperature cycle and to have lower transparency.

The polymer constituting the elastomeric core in the rubber particles is not limited, but preferably one including a (meth)acrylic ester as an essential monomer component. The (meth)acrylic ester is exemplified by methyl (meth)acrylate, ethyl (meth)acrylate, and butyl (meth)acrylate. The polymer constituting the elastomeric core may further include one or more other monomer components. Such other monomer components are exemplified by aromatic vinyls such as styrene and $\alpha$-methylstyrene; nitriles such as acrylonitrile and methacrylonitrile; conjugated dienes such as butadiene and isoprene; ethylene; propylene; and isobutene.

Among them, the polymer constituting the elastomeric core preferably includes at least one selected from the group consisting of aromatic vinyls, nitriles, and conjugated dienes, as a monomer component in combination with the (meth)acrylic ester. Specifically, the polymer constituting the core is exemplified by binary copolymers such as (meth)acrylic ester/aromatic vinyl copolymers and (meth)acrylic ester/conjugated diene copolymers; and ternary copolymers such as (meth)acrylic ester/aromatic vinyl/conjugated diene copolymers. The polymer constituting the core may include one or more other components such as silicones (e.g., polydimethylsiloxane and polyphenylmethylsiloxane) and polyurethanes.

The polymer constituting the core may further contain, as an additional monomer component, a reactive crosslinkable monomer having two ore more reactive functional groups per monomer (per molecule). The reactive crosslinkable monomer is exemplified by divinylbenzene, allyl (meth)acrylate, ethylene glycol di(meth)acrylate, diallyl maleate, triallyl cyanurate, diallyl phthalate, and butylene glycol diacrylate.

The core of the rubber particles is, among others, preferably one composed of a binary copolymer of (meth)acrylic ester/aromatic vinyl (particularly a copolymer of butyl acrylate/styrene). This is preferred for easy control of the refractive index of the rubber particles.

The core of the rubber particles can be produced by a commonly employed process, such as a process of polymerizing the monomer(s) by emulsion polymerization. In the emulsion polymerization, polymerization may be performed after charging the whole quantity of the monomer(s) at once, or by charging and polymerizing part of the monomer(s) and then adding the remainder continuously or intermittently for further polymerization. A polymerization process using seed particles may also be employed.

A polymer constituting the shell layer of the rubber particles is preferably a polymer of different type from that of the polymer constituting the core. The shell layer preferably has a hydroxyl group and/or a carboxy group as a functional group that is reactive with an epoxy-containing compound such as the alicyclic epoxy compound (A), as described above. This helps the shell layer to have better adhesiveness particularly at an interface with the alicyclic epoxy compound (A) and allows a cured product to exhibit excellent cracking resistance and to resist lowering in glass transition temperature, where the cured product is obtained by curing the curable epoxy resin composition including the rubber particles having this shell layer.

The polymer constituting the shell layer preferably includes a (meth)acrylic ester as an essential monomer component. The (meth)acrylic ester is exemplified by methyl (meth)acrylate, ethyl (meth)acrylate, and butyl (meth)acrylate. For example, assume that butyl acrylate is employed as the (meth)acrylic ester to constitute the core. In this case,

a (meth)acrylic ester other than butyl acrylate (e.g., methyl (meth)acrylate, ethyl (meth)acrylate, or butyl methacrylate) is preferably used as the monomer component to form the polymer constituting the shell layer. The polymer constituting the shell layer may further include one or more monomer components in addition to the (meth)acrylic ester(s). Such other monomer components are exemplified by aromatic vinyls such as styrene and α-methylstyrene; and nitriles such as acrylonitrile and methacrylonitrile. Monomer components to constitute the shell layer in the rubber particles preferably include, in addition to the (meth)acrylic ester(s), each of the aforementioned monomers alone or in combination and particularly preferably includes at least an aromatic vinyl. This is preferred for easy control of the refractive index of the rubber particles.

The polymer constituting the shell layer preferably further contains, as a monomer component, a hydroxyl-containing monomer and/or a carboxy-containing monomer. The hydroxyl-containing monomer is exemplified by hydroxyalkyl (meth)acrylates such as 2-hydroxyethyl (meth)acrylate. This is preferred so as to form a hydroxyl group and/or a carboxy group as a functional group that is reactive with an epoxy-containing compound such as the alicyclic epoxy compound (A). The carboxy-containing monomer is exemplified by α,β-unsaturated acids such as (meth)acrylic acid; and α,β-unsaturated acid anhydrides such as maleic anhydride.

The polymer constituting the shell layer in the rubber particles preferably includes, as a monomer component in addition to the (meth)acrylic ester(s), each monomer selected from the aforementioned monomers alone or in combination. Specifically, the shell layer is preferably one composed of a ternary copolymer such as a (meth)acrylic ester/aromatic vinyl/hydroxyalkyl (meth)acrylate copolymer or a (meth)acrylic ester/aromatic vinyl/α,β-unsaturated acid copolymer.

As with the polymer constituting the core, the polymer constituting the shell layer may contain, as an additional monomer component in addition to the monomer(s), a reactive crosslinkable monomer having two or more reactive functional groups per monomer (per molecule). The reactive crosslinkable monomer is exemplified by divinylbenzene, allyl (meth)acrylate, ethylene glycol di(meth)acrylate, diallyl maleate, triallyl cyanurate, diallyl phthalate, and butylene glycol diacrylate.

The rubber particles (rubber particles having a core-shell structure) may be obtained by covering the core with the shell layer. A way to cover the core with the shell layer is exemplified by a process of coating the surface of the elastomeric core obtained by the process with a copolymer to form the shell layer to cover the core with the shell layer; and a process of graft-polymerizing a backbone component and side-chain component(s), where the backbone component is the elastomeric core obtained by the process, and the side-chain component(s) is a component or components to constitute the shell layer.

The rubber particles may have an average particle diameter not critical, but preferably from 10 to 500 nm, and more preferably from 20 to 400 nm. The rubber particles may have a maximum particle diameter not critical, but preferably from 50 to 1000 nm, and more preferably from 100 to 800 nm. The rubber particles, if having an average particle diameter greater than 500 nm and/or having a maximum particle diameter greater than 1000 nm, may less satisfactorily disperse in the cured product, and this may cause the cured product to have inferior cracking resistance. In contrast, the rubber particles, if having an average particle diameter less than 10 nm and/or having a maximum particle diameter less than 50 nm, may less effectively help the cured product to have better cracking resistance.

The rubber particles may have a refractive index not critical, but preferably from 1.40 to 1.60, and more preferably from 1.42 to 1.58. The difference in refractive index is preferably within ±0.03, where the difference is between the rubber particles and a cured product obtained by curing the curable epoxy resin composition including the rubber particles (the curable epoxy resin composition according to the present invention). If the difference in refractive index is greater than ±0.03, the cured product may readily have inferior transparency and become cloudy occasionally to lower the luminous intensity of the optical semiconductor device. This may cause the optical semiconductor device to lose its function.

The refractive index of the rubber particles may be determined typically by casting 1 gram of the rubber particles in a mold; compression-molding the rubber particles at 210°C and 4 MPa to give a flat plate 1 mm thick; cutting a test specimen 20 mm long by 6 mm wide from the flat plate; and measuring a refractive index of the test specimen at the sodium D line at 20°C using a multi-wavelength Abbe refractometer (trade name DR-M2, supplied by ATAGO Co., Ltd.) while keeping a prism and the test specimen in intimate contact with each other using monobromonaphthalene as a contact liquid.

The refractive index of the cured product of the curable epoxy resin composition according to the present invention may be determined typically by preparing the cured product by a thermal curing method described in the aftermentioned optical semiconductor device; cutting a test specimen 20 mm long by 6 mm wide by 1 mm thick from the cured product; and measuring the refractive index of the test specimen at the sodium D line at 20°C using a multi-wavelength Abbe refractometer (trade name DR-M2, supplied by ATAGO Co., Ltd.) while keeping a prism and the test specimen in intimate contact with each other using monobromonaphthalene as a contact liquid.

The curable epoxy resin composition according to the present invention may include the rubber particles in a content (blending amount) not critical, but preferably from 0.5 to 30 parts by weight, and more preferably from 1 to 20

parts by weight, per 100 parts by weight of the total amount of epoxy-containing compounds in the curable epoxy resin composition. The curable epoxy resin composition, if including the rubber particles in a content less than 0.5 part by weight, may readily cause the cured product to have inferior cracking resistance. In contrast, the curable epoxy resin composition, if including the rubber particles in a content greater than 30 parts by weight, may readily cause the cured product to have inferior heat resistance.

Additives

The curable epoxy resin composition according to the present invention may further contain one or more of various additives within ranges not adversely affecting advantageous effects of the present invention, in addition to the aforementioned components. A hydroxyl-containing compound such as ethylene glycol, diethylene glycol, propylene glycol, or glycerol, when used as the additive, may help the reaction to proceed mildly. Other customary additives may also be used within ranges not adversely affecting the viscosity and transparency. Such additives are exemplified by silicone- or fluorine-containing antifoaming agents; leveling agents; silane coupling agents such as γ-glycidoxypropyltrimethoxysilane and 3-mercaptopropyltrimethoxysilane; surfactants; inorganic fillers such as silica and alumina; flame retardants; colorants; antioxidants; ultraviolet absorbers; ion adsorbents; pigments; phosphors; and mold-release agents.

Curable Epoxy Resin Composition Production Method

The curable epoxy resin composition according to the present invention has only to include at least the alicyclic epoxy compound (A), the monoallyl diglycidyl isocyanurate compound (B), the curing agent (C), and the curing accelerator (D) and may be produced (prepared) by any method not limited. Specifically, the curable epoxy resin composition may be prepared typically by mixing and stirring individual components in a predetermined ratio and, where necessary, performing debubbling in vacuo. Alternatively, but not limitatively, the curable epoxy resin composition may be prepared by preparing a composition (hereinafter also referred to as "epoxy resin") including epoxy-containing compounds such as the alicyclic epoxy compound (A) and the monoallyl diglycidyl isocyanurate compound (B) as essential components; separately preparing a composition (also referred to as "epoxy-curing agent") including the curing agent (C) and the curing accelerator (D) as essential components; mixing and stirring the the epoxy resin with the epoxy-curing agent in a predetermined ratio; and, where necessary, performing debubbling in vacuo.

A temperature in the mixing and stirring to prepare the epoxy resin is not critical, but preferably from 30°C to 150°C, and more preferably from 35°C to 130°C. A temperature in the mixing and stirring to prepare the epoxy-curing agent is also not critical, but preferably from 30°C to 100°C, and more preferably from 35°C to 80°C. The mixing and stirring may employ a known apparatus such as a planetary centrifugal mixer, planetary mixer, kneader, or dissolver.

Particularly when employing the alicyclic polyester resin as a component thereof, the curable epoxy resin composition is preferably prepared by initially mixing the alicyclic polyester resin with the curing agent (C) to give a mixture of them (mixture of the alicyclic polyester resin and the curing agent (C)); combining the mixture with the curing accelerator (D) and other optional additive(s) to prepare an "epoxy-curing agent"; and successively mixing the epoxy-curing agent with an "epoxy resin" separately prepared. This is preferred for obtaining a homogeneous composition. A temperature in the mixing of the alicyclic polyester resin with the curing agent (C) is not critical, but preferably from 60°C to 130°C, and more preferably from 90°C to 120°C. A mixing time is also not critical, but preferably from 30 to 100 minutes, and more preferably from 45 to 80 minutes. The mixing may be performed in any atmosphere, but preferably in a nitrogen atmosphere. The mixing may employ any of the known apparatuses as mentioned above.

Though not limited, the resulting mixture after mixing the alicyclic polyester resin and the curing agent (C) may be further subjected typically to an appropriate chemical treatment such as hydrogenation and/or terminal modification of the alicyclic polyester resin. In the mixture of the alicyclic polyester resin and the curing agent (C), part of the curing agent (C) may undergo a reaction with the alicyclic polyester resin (e.g., the hydroxyl group of the alicyclic polyester resin).

Cured Product

The curable epoxy resin composition according to the present invention, upon curing, can give a cured product that excels in heat resistance, light resistance, and thermal shock resistance and particularly excels in reflow resistance after moisture absorption. A heating temperature (curing temperature) upon curing is not critical, but preferably from 45°C to 200°C, more preferably from 100°C to 190°C, and furthermore preferably from 100°C to 180°C. A heating time (curing time) upon curing is not critical, but preferably from 30 to 600 minutes, more preferably from 45 to 540 minutes, and furthermore preferably from 60 to 480 minutes. Undesirably, curing, if performed at a temperature for a time each less than the lower limit of the range, may be insufficient; and, in contrast, curing, if performed at a temperature for a time each greater than the upper limit of the range, may cause the decomposition of resin components. Although depending on various other conditions, the curing conditions may be suitably adjusted typically such that the curing time

is set shorter at a higher curing temperature and is set longer at a lower curing temperature.

Resin Composition for Optical Semiconductor Encapsulation

The curable epoxy resin composition according to the present invention is preferably usable as a resin composition for optical semiconductor encapsulation. The curable epoxy resin composition upon the use as the resin composition for optical semiconductor encapsulation can give an optical semiconductor device including an optical semiconductor element encapsulated with a cured product, where the cured product has heat resistance, light resistance, and thermal shock resistance at high levels and particularly offers excellent reflow resistance after moisture absorption. The optical semiconductor device resists reduction in luminous intensity with time even when the optical semiconductor element is a high-output and high-brightness one. In particular, the optical semiconductor device resists deterioration such as luminous intensity reduction even upon heating in a reflow process after storage under high-humidity conditions.

Optical Semiconductor Device

The optical semiconductor device according to an embodiment of the present invention is an optical semiconductor device that includes an optical semiconductor element encapsulated with the cured product of the curable epoxy resin composition according to the present invention (resin composition for optical semiconductor encapsulation). The optical semiconductor element encapsulation may be performed by preparing the curable epoxy resin composition by the method; pouring the composition into a predetermined shaping mold; and heating and curing the composition under predetermined conditions. This gives an optical semiconductor device including the optical semiconductor element encapsulated with a cured product of the curable epoxy resin composition. The curing temperature and time may be set within ranges as in the cured product preparation.

Applications to which the curable epoxy resin composition according to the present invention is applicable are not limited to the optical semiconductor element encapsulation, but also include applications typically for or as adhesives, electrical insulating materials, laminated sheets, coating, inks, coating materials (paints), sealants, resists, composite materials, transparent substrates, transparent sheets, transparent films, optical devices, optical lenses, optical elements, stereolithographic materials, electronic papers, touch-screen panels, solar cell substrates, optical waveguides, light guide panels, and holographic memories.

Examples

The present invention will be illustrated in further detail with reference to several examples below. It should be noted, however, that the examples are by no means intended to limit the scope of the invention.

Production Example 1

Rubber Particles Production

In a 1-liter polymerization reactor equipped with a reflux condenser, were charged 500 g of ion-exchanged water and 0.68 g of sodium dioctyl sulfosuccinate, followed by temperature rise to 80°C with stirring in a nitrogen stream. This was combined with a first monomer mixture added at once, where the first monomer mixture contained 9.5 g of butyl acrylate, 2.57 g of styrene, and 0.39 g of divinylbenzene, and the amounts of the monomers corresponded to about 5 percent by weight of amounts necessary to form a core. The resulting mixture was stirred for 20 minutes to be emulsified, combined with 9.5 mg of potassium peroxodisulfate, and stirred for one hour to perform first seed polymerization. Next, the mixture was combined with 180.5 mg of potassium peroxodisulfate and stirred for 5 minutes. This was combined with a second monomer mixture added continuously over 2 hours to perform second seed polymerization, then aged for one hour, and yielded the core. The second monomer mixture had been prepared by dissolving 0.95 g of sodium dioctyl sulfosuccinate in 180.5 g of butyl acrylate, 48.89 g of styrene, and 7.33 g of divinylbenzene, where the amounts of the monomers corresponded to about 95 percent by weight of the amounts necessary to form the core.

Next, the resulting article was combined with 60 mg of potassium peroxodisulfate, stirred for 5 minutes, and further combined with a third monomer mixture added continuously over 30 minutes to perform seed polymerization. This was aged for one hour to form a shell layer covering the core. The third monomer mixture had been prepared by dissolving 0.3 g of sodium dioctyl sulfosuccinate in 60 g of methyl methacrylate, 1.5 g of acrylic acid, and 0.3 g of allyl methacrylate.

Next, the resulting mixture was cooled down to room temperature (25°C), filtrated using a plastic mesh with an opening of 120 μm, and yielded a latex including rubber particles having a core-shell structure. The resulting latex was frozen at minus 30°C, washed/dewatered with a suction filter, dried with air blow at 60°C for the whole day and night,

and yielded rubber particles. The resulting rubber particles had an average particle diameter of 254 nm and a maximum particle diameter of 486 nm.

The average particle diameter and maximum particle diameter of the rubber particles were determined in the following manner. A sample was subjected to measurement using the Nanotrac Particle Size Analyzer (trade name UPA-EX150, supplied by Nikkiso Co., Ltd.) of "Nanotrac™" system based on dynamic light scattering as a measurement principle. In a particle size distribution curve obtained by the measurement, a cumulative average diameter, which is the particle diameter at which the cumulative curve reaches 50%, was defined as the average particle diameter; and a maximum (largest) particle diameter, at which the frequency (%) of the measured particle size distribution exceeds 0.00%, was defined as the maximum particle diameter. The sample was prepared by dispersing 1 part by weight of a rubber-particle-dispersed epoxy compound in 20 parts by weight of tetrahydrofuran, where the rubber-particle-dispersed epoxy compound was obtained in Production Example 2 as follows.

Production Example 2

Production of Rubber-particle-dispersed Epoxy Compound

In a nitrogen stream, 10 parts by weight of the rubber particles obtained in Production Example 1 and heated at 60°C was dispersed in 70 parts by weight of trade name CELLOXIDE 2021P (3,4-epoxycyclohexylmethyl (3,4-epoxy)cyclohexanecarboxylate, supplied by Daicel Corporation) using a dissolver at 1000 rpm for 60 minutes, debubbled in vacuo, and yielded a rubber-particle-dispersed epoxy compound having a viscosity at 25°C of 724 mPa·s.

The viscosity (viscosity at 25°C) of the rubber-particle-dispersed epoxy compound obtained in Production Example 2 was measured with a digital viscometer (trade name Model DVU-EII, supplied by Tokimec, Inc.). The rubber-particle-dispersed epoxy compound included 10 parts by weight of the rubber particles dispersed in 70 parts by weight of CELLOXIDE 2021P.

Production Example 3

Epoxy Resin Production

Materials were uniformly mixed with one another in blending ratios (in part by weight) given in Tables 1 and 2 using a planetary centrifugal mixer (AWATORIRENTARO (Thinky Mixer) AR-250 supplied by THINKY CORPORATION) with debubbling, and yielded epoxy resins (epoxy resins in Examples and Comparative Examples 2 to 6). The materials included CELLOXIDE 2021P (trade name, alicyclic epoxy compound, supplied by Daicel Corporation); monoallyl diglycidyl isocyanurate (MA-DGIC, supplied by SHIKOKU CHEMICALS CORPORATION); X-40-2678 (trade name, a siloxane derivative having two epoxy groups per molecule, supplied by Shin-Etsu Chemical Co., Ltd.); X-40-2720 (trade name, a siloxane derivative having three epoxy groups per molecule, supplied by Shin-Etsu Chemical Co., Ltd.); X-40-2670 (trade name, a siloxane derivative having four epoxy groups per molecule, supplied by Shin-Etsu Chemical Co., Ltd.); YD-128 (trade name, a bisphenol-A epoxy resin, supplied by Nippon Steel Chemical Co., Ltd.); and the rubber-particle-dispersed epoxy resin obtained in Production Example 2. When MA-DGIC was used as a component of the epoxy resin, the mixing was performed by stirring at 80°C for one hour to dissolve MA-DGIC. The symbol "-" in Tables 1 and 2 indicates that a component in question was not formulated, and the same is also true for the following description.

Production Example 4

Alicyclic Polyester Resin Production

Materials were charged in a reactor equipped with a stirrer, a thermometer, and a reflux condense, heated up to 160°C, and further heated from 160°C up to 250°C over 4 hours. The materials were 172 parts by weight of 1,4-cyclohexanedicarboxylic acid (supplied by Tokyo Chemical Industry Co., Ltd.), 208 parts by weight of neopentyl glycol (supplied by Tokyo Chemical Industry Co., Ltd.), and 0.1 part by weight of tetrabutyl titanate (supplied by Wako Pure Chemical Industries, Ltd.). Next, the resulting mixture was decompressed to 5 mmHg over one hour, further decompressed to 0.3 mmHg or less, then allowed to react at 250°C for one hour, and yielded an alicyclic polyester resin.

The resulting alicyclic polyester resin had a number-average molecular weight of 5300. The number-average molecular weight of the alicyclic polyester resin was a value as determined by measuring a retention time (retention volume) of the alicyclic polyester resin by gel permeation chromatograph (GPC); and converting the retention time into a molecular weight in terms of a polystyrene standard based on the retention time (retention volume) of the polystyrene standard whose molecular weight had been already known by measurement under the same conditions. Specifically, the measurement was performed with the gel permeation chromatograph HLC-8220GPC (trade name, supplied by

Tosoh Corporation) with a total of four columns, i.e., one TSKgel G2000HHR column, two TSKgel G1000HHR columns, and one guard column TSKgel HHR-L (trade names, each supplied by Tosoh Corporation) and a differential refractometer as a detector, using tetrahydrofuran as a mobile phase at a measurement temperature of 40°C and a flow rate of 1 mL/min.

Production Example 5

Epoxy-curing Agent Production

Materials were uniformly mixed in blending ratios (in part by weight) given in Tables 1 and 2 using the planetary centrifugal mixer (AWATORIRENTARO (Thinky Mixer) AR-250 supplied by THINKY CORPORATION) with debubbling and yielded epoxy-curing agents. The materials include RIKACID MH-700 (trade name, a curing agent, supplied by New Japan Chemical Co., Ltd.); RIKACID HNA-100 (trade name, a curing agent, supplied by Hitachi Chemical Company, Ltd.); the alicyclic polyester resin obtained in Production Example 4; U-CAT 18X (trade name, a curing accelerator, supplied by San-Apro Ltd.); and ethylene glycol (an additive, supplied by Wako Pure Chemical Industries, Ltd.). Each of the epoxy-curing agents is hereinafter also referred to as "Agent K".

Example 1

The epoxy resin obtained in Production Example 3 and the epoxy-curing agent obtained in Production Example 5 were uniformly mixed with each other so as to be in a blending ratio (in part by weight) given in Table 1 and debubbled using the planetary centrifugal mixer (trade name AWATORIRENTARO (Thinky Mixer) AR-250, supplied by THINKY CORPORATION), and yielded a curable epoxy resin composition.

The above-obtained curable epoxy resin composition was cast in a lead frame of an optical semiconductor (InGaN element, 3.5 mm by 2.8 mm) as illustrated in Fig. 1, heated in an oven (resin curing oven) at 120°C for 5 hours, and thereby yielded an optical semiconductor device including the optical semiconductor element encapsulated with a cured product of the curable epoxy resin composition. Fig. 1 illustrates a reflector (resin composition for light reflection) 100, metal lines 101, the optical semiconductor element 102, bonding wires 103, and the cured product (encapsulant) 104.

Examples 2 to 11 and Comparative Examples 1 to 9

Curable epoxy resin compositions were prepared by the procedure of Example 1, except for employing different formulations of the curable epoxy resin compositions as given in Tables 1 and 2. In addition, optical semiconductor devices were produced by the procedure of Example 1.

Evaluations

The optical semiconductor devices obtained in the examples and comparative examples were subjected to evaluation tests as follows.

Power-on Test

A total luminous flux of each of the optical semiconductor devices obtained in the examples and comparative examples was measured with a total luminous flux measurement system, and this was defined as "initial total luminous flux". Each optical semiconductor device was then applied with a current of 30 mA in a thermostat at 85°C for 100 hours, a total luminous flux was measured thereafter, and this was defined as "total luminous flux after 100 hrs". Based on these, a luminous intensity retention was calculated according to an expression as follows. The results are indicated in "Luminous intensity retention [%]" in Tables 1 and 2.

$$[\text{Luminous intensity retention (\%)}]=[\text{Total luminous flux after 100 hrs (lm)}]/[\text{Initial total luminous flux (lm)}]\times 100$$

Soldering Heat Resistance Test

The optical semiconductor devices (two devices per curable epoxy resin composition) obtained in the examples and comparative examples were subjected to a moisture absorbing treatment by leaving stand at an ambient temperature

of 30°C and 70% relative humidity for 192 hours. Next, the optical semiconductor devices were placed in a reflow oven and subjected to a heat treatment under heating conditions below. The optical semiconductor devices were then retrieved to a room-temperature environment, naturally cooled, placed again in the reflow oven, and heat-treated under the same conditions. Specifically, a thermal hysteresis under the following heating conditions was applied two times to the optical semiconductor devices in the soldering heat resistance test.

Heating Conditions (in terms of optical semiconductor device surface temperature)

(1) Preheating: 150°C to 190°C for 60 to 120 seconds
(2) Heating after preheating: 217°C or higher for 60 to 150 seconds, at a highest temperature of 260°C

The rate of temperature rise in transfer from the preheating to heating was controlled to 3°C/second or less.

Fig. 2 depicts an exemplary surface temperature profile (temperature profile in one of the two heat treatments) of the optical semiconductor devices upon heating in the reflow oven.

The optical semiconductor devices were thereafter observed with a digital microscope (trade name VHX-900, supplied by Keyence Corporation) to evaluate whether or not a crack with a length of 90 μm or more occurred in the cured product; and whether or not electrode peeling (peeling of the cured product from the electrode surface) occurred. Of the two optical semiconductor device specimens, the number of optical semiconductor devices suffering from a crack with a length of 90 μm or more in the cured product is indicated in "Soldering heat resistance test [cracking number]" in Tables 1 and 2; and the number of optical semiconductor devices suffering from electrode peeling is indicated in "Soldering heat resistance test [electrode peeling number]" in Tables 1 and 2.

Thermal Shock Test

Using a thermal shock tester, 200 cycles of thermal shock were applied to the optical semiconductor devices (two devices per curable epoxy resin composition) obtained in the examples and comparative examples. In one cycle, the devices were exposed to an ambient temperature of -40°C for 30 minutes and subsequently exposed to an ambient temperature of 120°C for 30 minutes. After the thermal shock application, the length of a crack occurring in the cured product in each optical semiconductor device was observed with the digital microscope (trade name VHX-900, supplied by Keyence Corporation). Of the two optical semiconductor device specimens, the number of optical semiconductor devices suffering from a crack with a length of 90 μm or more in the cured product was counted. The results are indicated in "Thermal shock test [cracking number]" in Tables 1 and 2.

Overall Judgment

Based on the test results, a sample meeting all conditions (1) to (4) as follows was evaluated as "good"; whereas a sample not meeting at least one of the conditions (1) to (4) was evaluated as "failed".

(1) Power-on test: Luminous intensity retention of 90% or more;
(2) Soldering heat resistance test: The number of optical semiconductor devices suffering from a crack with a length of 90 μm or more in the cured product is zero;
(3) Soldering heat resistance test: The number of optical semiconductor devices suffering from electrode peeling is zero; and
(4) Thermal shock test: The number of optical semiconductor

devices suffering from a crack with a length of 90 μm or more in the cured product is zero.

The results are indicated in "Overall judgment" in Tables 1 and 2.

[Table 1]

TABLE 1

| | | | Example 1 | Example 2 | Example 3 | Example 4 | Example 5 | Example 6 | Example 7 | Example 8 | Example 9 | Example 10 | Example 11 |
|---|---|---|---|---|---|---|---|---|---|---|---|---|---|
| Curable epoxy resin composition | Epoxy resin [part by weight] | CEL2021P | 90 | 80 | 70 | 50 | 90 | 90 | 56 | 56 | 56 | 56 | 70 |
| | | MA-DGIC | 10 | 20 | 30 | 50 | 10 | 10 | 24 | 24 | 24 | 24 | 20 |
| | | X-40-2678 | - | - | - | - | - | - | 20 | 20 | - | - | - |
| | | X-40-2720 | - | - | - | - | - | - | - | - | 20 | - | - |
| | | X-40-2670 | - | - | - | - | - | - | - | - | - | 20 | - |
| | | YD-128 | - | - | - | - | - | - | - | - | - | - | - |
| | | Rubber particles | - | - | - | - | - | - | - | - | - | - | 10 |
| | Epoxy-curing agent (AgentK) [part by weight] | MH-700 | - | - | - | - | - | 20 | - | - | - | - | - |
| | | HNA-100 | 100 | 100 | 100 | 100 | 100 | 80 | 100 | 100 | 100 | 100 | 100 |
| | | Alicyclic polyester resin | - | - | - | - | 20 | - | - | 20 | - | - | - |
| | | U-CAT 18X | 0.5 | 0.5 | 0.5 | 0.5 | 0.5 | 0.5 | 0.5 | 0.5 | 0.5 | 0.5 | 0.5 |
| | | Ethylene glycol | 1 | 1 | 1 | 1 | 1 | 1 | 1 | 1 | 1 | 1 | 1 |
| Cured product (optical semiconductor device) | Luminous intensity retention [%] | | 91 | 93 | 92 | 94 | 98 | 90 | 99 | 100 | 98 | 96 | 96 |
| | Soldering heat resistance test [cracking number] | | 0 | 0 | 0 | 0 | 0 | 0 | 0 | 0 | 0 | 0 | 0 |
| | Soldering heat resistance test [electrode peeling number] | | 0 | 0 | 0 | 0 | 0 | 0 | 0 | 0 | 0 | 0 | 0 |
| | Thermal shock test [cracking number] | | 0 | 0 | 0 | 0 | 0 | 0 | 0 | 0 | 0 | 0 | 0 |
| | Overall judgment | | Good | Good | Good | Good | Good | Good | Good | Good | Good | Good | Good |

[Table 2]

TABLE 2

| | | | Comparative Example 1 | Comparative Example 2 | Comparative Example 3 | Comparative Example 4 | Comparative Example 5 | Comparative Example 6 | comparative Example 7 | Comparative Example 8 | Comparative Example 9 |
|---|---|---|---|---|---|---|---|---|---|---|---|
| Curable epoxy resin composition | Epoxy resin [part by weight] | CEL2021P | 100 | 90 | 80 | 70 | 50 | 80 | - | - | - |
| | | MA-DGIC | - | 10 | 20 | 30 | 50 | - | - | - | - |
| | | X-40-2678 | - | - | - | - | - | - | 100 | - | - |
| | | X-40-2720 | - | - | - | - | - | - | - | 100 | - |
| | | X-40-2670 | - | - | - | - | - | - | - | - | 100 |
| | | YD-128 | - | - | - | - | - | 20 | - | - | - |
| | Epoxy-curing agent (Agent K) [part by weight] | MH-700 | 100 | 100 | 100 | 100 | 100 | 100 | 100 | 100 | 100 |
| | | HNA-100 | - | - | - | - | - | - | - | - | - |
| | | Alicyclic polyester resin | - | - | - | - | - | - | - | - | - |
| | | U-CAT 18X | 0.5 | 0.5 | 0.5 | 0.5 | 0.5 | 0.5 | 0.5 | 0.5 | 0.5 |
| | | Ethylene glycol | 1 | 1 | 1 | 1 | 1 | 1 | 1 | 1 | 1 |
| Cured product (optical semiconductor device) | Luminous intensity retention [%] | | 78 | 84 | 85 | 87 | 89 | 74 | 98 | 95 | 96 |
| | Soldering heat resistance test [cracking number] | | 2 | 0 | 0 | 0 | 0 | 0 | 0 | 0 | 0 |
| | Soldering heat resistance test [electrode peeling] | | 2 | 2 | 2 | 2 | 2 | 2 | 2 | 2 | 2 |
| | Thermal shock test [cracking number] | | 2 | 0 | 0 | 0 | 0 | 0 | 2 | 2 | 2 |
| | Overall judgment | | Failed | Failed | Failed | Failed | Failed | Failed | Failed | Failed | Failed |

The components used in the examples and comparative examples are as follows:

Epoxy Resin

CEL2021P (CELLOXIDE 2021P): 3,4-Epoxycyclohexylmethyl (3,4-epoxy)cyclohexanecarboxylate, supplied by Daicel Corporation
MA-DGIC: Monoallyl diglycidyl isocyanurate, supplied by SHIKOKU CHEMICALS CORPORATION
X-40-2678: Siloxane derivative having two epoxy groups per molecule, supplied by Shin-Etsu Chemical Co., Ltd.
X-40-2720: Siloxane derivative having three epoxy groups per molecule, supplied by Shin-Etsu Chemical Co., Ltd.
X-40-2670: Siloxane derivative having four epoxy groups per molecule, supplied by Shin-Etsu Chemical Co., Ltd.
YD-128: Bisphenol-A epoxy resin, supplied by Nippon Steel Chemical Co., Ltd.

Agent K

MH-700 (RIKACID MH-700): 70:30 Mixture of 4-methylhexahydrophthalic anhydride and hexahydrophthalic anhydride, supplied by New Japan Chemical Co., Ltd.
HNA-100 (RIKACID HNA-100): Mixture of methylnorbornane-2,3-dicarboxylic anhydride and norbornane-2,3-dicarboxylic anhydride (the mixture having a succinic anhydride content of 0.4 percent by weight or less)
U-CAT 18X: Curing accelerator, supplied by San-Apro Ltd.
Ethylene glycol: Product supplied by Wako Pure Chemical Industries, Ltd.

Testing Instrument

Resin Curing Oven

GPHH-201 supplied by ESPEC Corporation

Thermostat

Desk-top Type High-temperature Chamber ST-120B1 supplied by ESPEC Corporation

Total Luminous Flux Measurement System

Multi-channel Spectroradiometric Measurement System OL771, supplied by Optronic Laboratories, Inc.

Thermal Shock Tester

Compact Thermal Shock Chamber TSE-11-A, supplied by ESPEC Corporation

Reflow Oven

UNI-5016F, supplied by NIPPON ANTOM CO., LTD.

Industrial Applicability

The curable epoxy resin composition according to the present invention is preferably usable as a resin composition for optical semiconductor encapsulation. The curable epoxy resin composition according to the present invention is also usable in applications such as adhesives, electrical insulating materials, laminated sheets, coating, inks, coating materials (paints), sealants, resists, composite materials, transparent substrates, transparent sheets, transparent films, optical devices, optical lenses, optical elements, stereolithographic materials, electronic papers, touch-screen panels, solar cell substrates, optical waveguides, light guide panels, and holographic memories.

Reference Signs List

100 reflector (resin composition for light reflection)

101 metal line
102 optical semiconductor element
103 bonding wire
104 cured product (encapsulant)

## Claims

**1.** A curable epoxy resin composition comprising:

an alicyclic epoxy compound (A);
a monoallyl diglycidyl isocyanurate compound (B);
a curing agent (C); and
a curing accelerator (D),
where the monoallyl diglycidyl isocyanurate compound (B) is represented by Formula (1):

[Chem. 1]

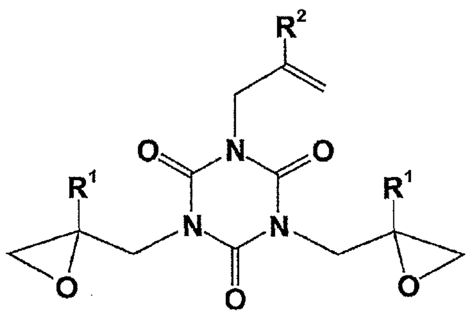

(1)

wherein $R^1$ and $R^2$ are identical or different and are independently selected from a hydrogen atom and an alkyl group having 1 to 8 carbon atoms;
the curable epoxy resin composition comprising a methylnorbornane-2,3-dicarboxylic anhydride as an essential component of the curing agent (C); and
a content of succinic anhydride being 0.4 percent by weight or less based on the total amount of the curing agent (C).

**2.** The curable epoxy resin composition according to claim 1, further comprising norbornane-2,3-dicarboxylic anhydride as the curing agent (C) in addition to the methylnorbornane-2,3-dicarboxylic anhydride.

**3.** The curable epoxy resin composition according to one of claims 1 and 2, wherein the alicyclic epoxy compound (A) is a compound containing a cyclohexane oxide group.

**4.** The curable epoxy resin composition according to any one of claims 1 to 3, wherein the alicyclic epoxy compound (A) is a compound represented by Formula (I-1):

[Chem. 2]

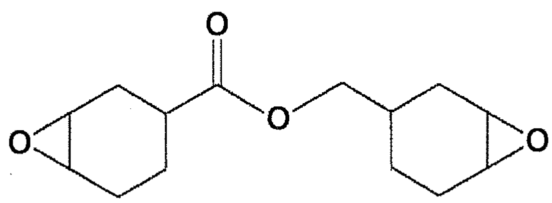

(I-1)

**5.** The curable epoxy resin composition according to any one of claims 1 to 4, further comprising a siloxane derivative having at least two epoxy groups per molecule.

6. The curable epoxy resin composition according to any one of claims 1 to 5, further comprising an alicyclic polyester resin.

7. The curable epoxy resin composition according to any one of claims 1 to 6, further comprising rubber particles.

8. A cured product obtained by curing the curable epoxy resin composition of any one of claims 1 to 7.

9. The curable epoxy resin composition according to any one of claims 1 to 7, as a resin composition for optical semiconductor encapsulation.

10. An optical semiconductor device comprising an optical semiconductor element encapsulated with the cured product of the curable epoxy resin composition of claim 9.

Fig. 1

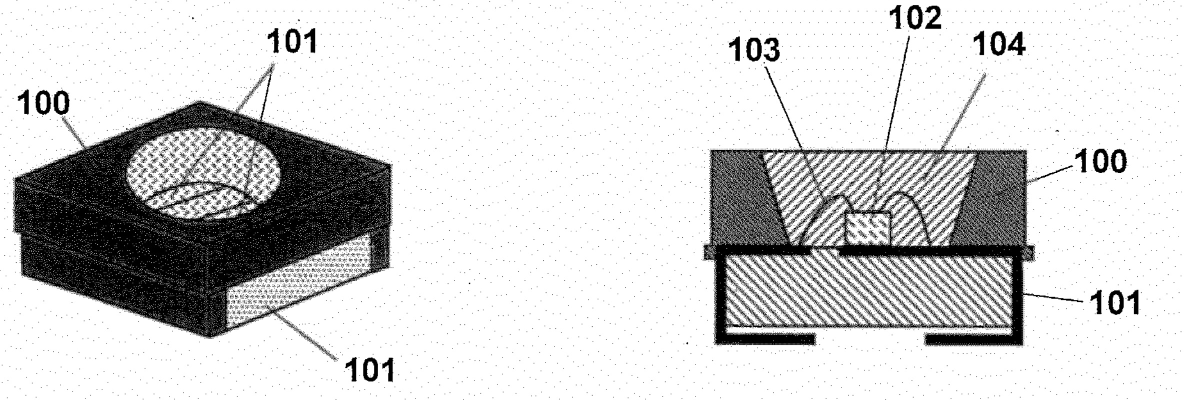
100
101
101
103
102
104
100
101

(a) (b)

Fig. 2

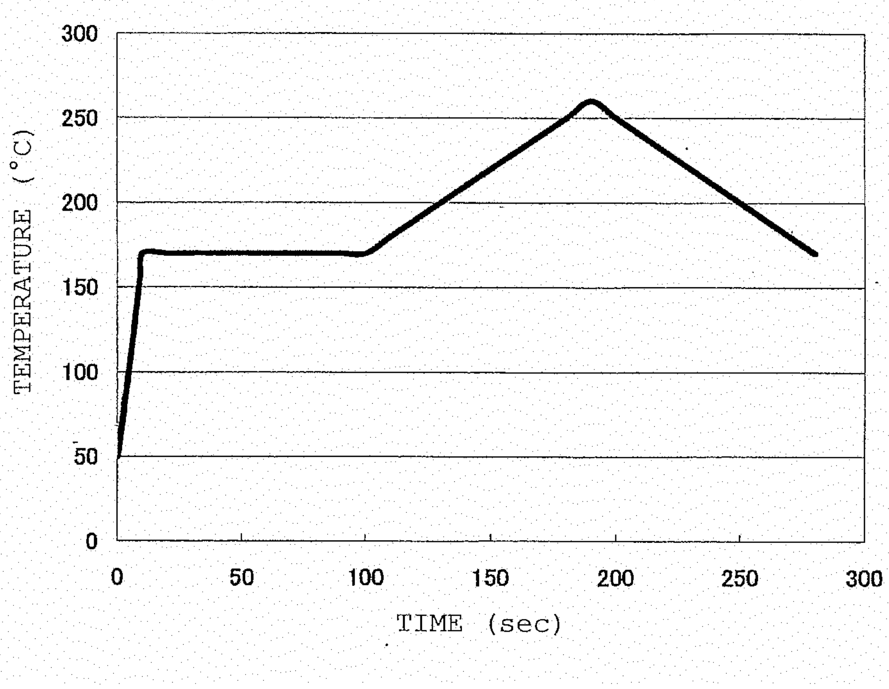
300
250
200
150
100
50
0
TEMPERATURE (°C)
0
50
100
150
200
250
300
TIME (sec)

## INTERNATIONAL SEARCH REPORT

International application No.
PCT/JP2013/058072

A. CLASSIFICATION OF SUBJECT MATTER
*C08G59/26*(2006.01)i, *C08G59/24*(2006.01)i, *C08G59/42*(2006.01)i, *C08L67/00*(2006.01)i, *H01L23/29*(2006.01)i, *H01L23/31*(2006.01)i

According to International Patent Classification (IPC) or to both national classification and IPC

B. FIELDS SEARCHED

Minimum documentation searched (classification system followed by classification symbols)
C08G59/00-59/72, C08L1/00-101/14, H01L23/29, H01L23/31

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2013 |
| Kokai Jitsuyo Shinan Koho | 1971-2013 | Toroku Jitsuyo Shinan Koho | 1994-2013 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2011-157462 A (Daicel Chemical Industries, Ltd.), 18 August 2011 (18.08.2011), entire text & US 2012/0248498 A1 & EP 2532693 A1 & WO 2011/093219 A1 & TW 201139498 A & CN 102686634 A & KR 10-2012-0125510 A | 1-10 |
| A | JP 2011-148972 A (Toray Industries, Inc.), 04 August 2011 (04.08.2011), entire text (Family: none) | 1-10 |
| A | JP 2000-344867 A (Shikoku Kasei Co., Ltd.), 12 December 2000 (12.12.2000), entire text (Family: none) | 1-10 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 18 June, 2013 (18.06.13) | 25 June, 2013 (25.06.13) |

| Name and mailing address of the ISA/ | Authorized officer |
|---|---|
| Japanese Patent Office | |
| Facsimile No. | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2000344867 A
- JP H0625207 A
- JP 2008248169 A
- JP 2008019422 A